# EUROPEAN PATENT APPLICATION

(11) **EP 2 741 339 A1**
(43) Date of publication of application: **11.06.2014**
(21) Application number: 12819591.4
(22) Date of filing: 03.07.2012
(51) Int. Cl.: H01L 33/50, C09K 11/00, C09K 11/08, C09K 11/59, C09K 11/73

(54) **OPTICAL WAVELENGTH CONVERSION MEMBER**

(30) Priority: 02.08.2011 JP 2011169214
(71) Applicant: Koito Manufacturing Co., Ltd., Tokyo 108-8711 (JP)
(72) Inventor: DAICHO, Hisayoshi, Shizuoka-shi Shizuoka 424-8764 (JP); ENOMOTO, Kiminori, Shizuoka-shi Shizuoka 424-8764 (JP)
(74) Representative: Algemeen Octrooi- en Merkenbureau B.V.
(86) International application number: PCT/JP2012/004286
(87) International publication number: WO 2013/018278

(57) **Abstract**

In a light wavelength conversion member 16, a translucent 30 encapsulates a yellow phosphor 32 and a blue phosphor 34. The yellow phosphor 32 is excited by light ranging from near-ultraviolet light to short-wavelength visible light whose dominant wavelength is 350 nm to 480 nm and then emits yellow light. The blue phosphor (34) is excited by light ranging from near-ultraviolet light to short-wavelength visible light whose dominant wavelength is 350 nm to 480 nm and then emits blue light. The difference in refractive index between each of the yellow phosphor 32 and the blue phosphor 34 and the translucent member 30 is less than or equal to 0.2.

## Description

### [Technical Field]

The present invention relates to a light wavelength conversion member and, in particular, a light wavelength conversion member including a fluorescent material (phosphor) and a translucent member containing the phosphor.

### [Background Art]

Known are various types of light emitting modules so structured as to obtain light of a desired color. Here, the light of a desired color is obtained by combining a light-emitting element and a phosphor that generates light, which is excited by the light generated by said light-emitting element, having a wavelength band different from that of said light-emitting element.

A light emitting module has been the focus of attention in recent years in particular, as a white light emitting module having a longer life and consuming less power. This light emitting module is so structured as to obtain white light by combining a semiconductor element and a phosphor where the semiconductor light-emitting element is an excitation light source. Here, the semiconductor light-emitting element may be a light emitting diode (LED) that emits an ultraviolet ray or short-wavelength visible light, for instance. Known examples of such a white light emitting module includes a method where an LED, which emits the ultraviolet ray or short-wavelength visible light, and phosphors, which emit blue and yellow lights, respectively, excited by the ultraviolet ray or short-wavelength visible light are used and then a plurality of such elements are combined together (see Patent Document 1, for instance).

### [Related Art Documents]

### [Patent Documents]

[Patent Document 1] Japanese Unexamined Patent Application Publication (Kokai) No. 2009-38314.

### [Disclosure of Invention]

### [Problems to be Solved by the Invention]

The aforementioned light wavelength conversion member or the like, where the phosphor is sealed, is placed on a transparent material in such a manner as to face a light emitting surface of the light-emitting element. Thereby, white light can be obtained using light whose wavelength has been converted by the phosphor. When, however, the wavelength of light is converted by the phosphor, light may possibly disperse due to a difference in the refractive index between the phosphor and the transparent material. The occurrence of such light dispersion accelerates the attenuation of light inside the light wavelength conversion member, so that it may be difficult to enhance the extraction efficiency of light.

The present invention has been made to solve the above-described problems, and a purpose thereof is to enhance the extraction efficiency of light by a light wavelength conversion member where a phosphor is sealed in a transparent material.

### [Means for Solving the Problem]

In order to resolve the above-described problems, a light wavelength conversion member according to one embodiment of the present invention includes: a phosphor; and a translucent member containing the phosphor. The difference in refractive index between the phosphor and the translucent member is less than or equal to 0.2.

It was verified, through the results of research and development done by the inventors of the present invention, that both the light flux and the luminance can be appropriately enhanced, if, in this manner, the difference in refractive index between the phosphor and the translucent member is 0.2 or below. By employing this embodiment, therefore, the extraction efficiency of light by the light wavelength conversion member can be enhanced.

The phosphor may include: a blue phosphor that is excited by light whose wavelength ranges from 350 nm to 480 nm and emits blue light; and a yellow phosphor that is excited by light whose wavelength ranges from 350 nm to 480 nm and emits yellow light. The difference in refractive index between each of the blue phosphor and the yellow phosphor and the translucent member may be less than or equal to 0.2.

Presently known is a light wavelength conversion member whereby white light is emitted using a blue phosphor and a yellow phosphor that are excited by near-ultraviolet light or short-wavelength visible light. In such a light wavelength conversion member, it is preferable that as much light as possible out of the light rays that have entered be emitted after the wavelength thereof has been converted. On the other hand, much light needs to be excited by the phosphors and therefore the extraction efficiency of light is more likely to deteriorate in such a light wavelength conversion member because of the dispersion of light. It was verified, through the results of research and development done by the inventors, that both the light flux and the luminance can be appropriately enhanced, if, as described above, the difference in refractive index is 0.2 or below in the light wavelength conversion member containing the blue phosphors and the yellow phosphors that are excited by near-ultraviolet light or short-wavelength visible light. Thus this embodiment can enhance the extraction efficiency of light by the light wavelength conversion member containing the blue phosphors and the yellow phosphors that are excited by near-ultraviolet light or short-wavelength visible light.

A general formula of the yellow phosphor is (Ca_{1x-y-z-w}, Srₓ, M^{II}_{y}, Eu_{z}, M^{R}_{W})₇(M^{IV}O₃)₆X₂. Here, M^{II} indicates Mg, Ba, or Zn. M^{R} indicates a rare-earth element or Mn. M^{IV}, which contains Si as an essential component, is partially replaceable by at least one type of element selected from the group consisting of Ge, Ti, Zr, and Sn. X, which contains Cl as an essential component, indicates at least one type of halogen element. x, y, z, and w each lies in a range such that 0.1<x<0.7, 0≤ y<0.3, 0<z<0.4, and 0<w<0.1, respectively.

It was turned out, through the results of research and development done by the inventors, that this yellow phosphor has a refractive index lower than that of a general YAG (yttrium-aluminum-garnet)-based phosphor or the like. The refractive index of a translucent member that seals off the phosphors is normally lower than that of the phosphors. Thus, by employing this embodiment, the difference in refractive index between translucent member and the phosphors can be made lower.

A general formula of the blue phosphor is M¹ₐ(M²O₄)_{b}X_{c}:Re_{d}. Here, M¹ contains, as an essential component, at least one type of element selected from the group consisting of Ca, Sr, and Ba, and is partially replaceable by at least one type of element selected from the group consisting of Mg, Zn, Cd, K, Ag, and Tl. M², which contains at least P as an essential component, is partially replaceable by at least one type of element selected from the group consisting of V, Si, As, Mn, Co, Cr, Mo, W, and B. X indicates at least one type of halogen element. Re, which contains Eu²⁺ as an essential component, indicates at least one type of rare-earth element or Mn. a, b, c, and d each lies in a range such that 2≤a≤5.8, 2.5≤b≤3.5, 0.8<c<1.4, and 0.01<d<0.1, respectively.

It was turned out, through the results of research and development conducted by the inventors, that this blue phosphor has a refractive index lower than that of the general YAG-based phosphor or the like. Thus, by employing this embodiment, the difference in refractive index between translucent member and the phosphors can be reduced to an appropriate lower value.

The translucent member may contain inorganic amorphous material. The inorganic amorphous material has a refractive index higher than that of a transparent resin (e.g., silicone resin, fluororesin, or the like), which excels in photo-deterioration resistance, for instance. The refractive index of a translucent member that seals off the phosphors is normally lower than of that of the phosphors. Thus, by employing this embodiment, the difference in refractive index between translucent member and the phosphors can be reduced to an appropriate lower value.

### [Advantageous Effects]

The present invention can enhance the extraction efficiency of light by a light wavelength conversion member where a phosphor is sealed in a transparent material.

### [Brief Description of Drawings]

FIG. 1 is a cross-sectional view showing a structure of a light emitting module used in each exemplary embodiment and each comparative example;
FIG.2 shows the emission spectrum of a semiconductor light-emitting element, the emission spectrum of B phosphor, and the emission spectrum of Y phosphor;
FIG. 3 shows a composition of glass used in each exemplary embodiment;
FIG. 4 shows the refractive index of glass of each composition used in an exemplary embodiment;
FIG. 5 shows the material used for a translucent member, the refractive index of the translucent member, the difference in the refractive index between the translucent member and Y phosphor and B phosphor, the density of phosphors, and the thickness of a light wavelength conversion member, where the Y phosphor and the B phosphor are encapsulated, in each exemplary embodiment; and
FIG. 6 shows the luminous flux ratio and the luminance ratio of light emitted from a light emitting module, in each exemplary embodiment and each comparative example.

### [Mode for Carrying Out the Invention]

The exemplary embodiments of the present invention will be described in detail, with reference to the accompanying drawings, by comparing them with comparative examples.

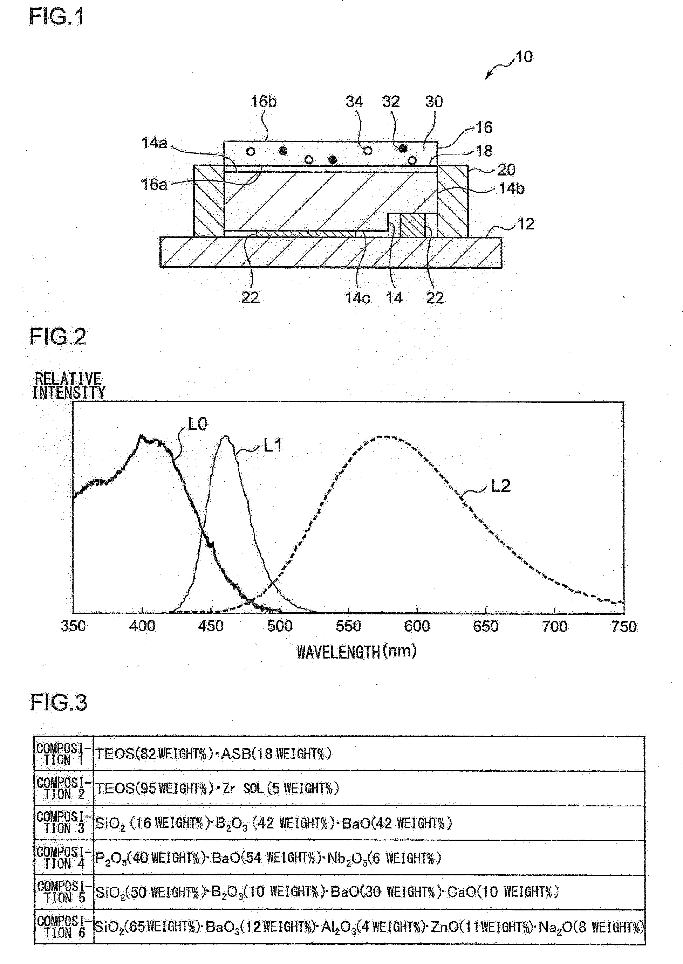

FIG. 1 is a cross-sectional view showing a structure of a light emitting module 10 used in each exemplary embodiment and each comparative example. The light emitting module 10 includes a substrate 12, a semiconductor light-emitting element 14, a light wavelength conversion member 16, and a shielding frame 20.

The substrate 12 used herein is formed of AlN (aluminum nitride). A pattern having a form of electrode is provided on top of the substrate 12 with Au. It goes without saying that the material constituting the substrate 12 is not limited to AlN, and the substrate 12 may be formed of other material such as alumina, silicon, mullite, aluminum or copper.

A flip-chip type LED is used as the semiconductor light-emitting element 14. An underside 14c of the semiconductor light-emitting element 14 is bonded and thereby secured to the pattern of the substrate 12 with the Au bump 22 held between the semiconductor light-emitting element 14 and the substrate 12. It is to be noted here that the semiconductor light-emitting element 14 is not limited to the flip-chip type only and, for example, it may be a face-up type or vertical chip type. The semiconductor light-emitting element 14 used herein is one that generates light ranging from near-ultraviolet light to short-wavelength visible light whose dominant wavelength ranges from 350 nm to 480 nm (inclusive).

The shielding frame 20 is formed such that an inner shape of the shielding frame 20 is approximately identical to an external shape of the semiconductor light-emitting element 14. Thus, the shielding frame 20 is fixed to the substrate 12 in such a manner as to surround a side face 14b of the semiconductor light-emitting element 14. And the shielding frame 20 is arranged such that the shielding frame 20 is mostly in contact with the side face 14b of the semiconductor light-emitting element 14. The shielding frame 20 may be provided such that there is a spacing between the shielding frame 20 and the side face 14b. Also, an inner surface of the shielding frame 20 may be subjected to a process by which to enhance reflectance, such as a process of coating it with aluminum, silver, titanium oxide, or the like.

The light wavelength conversion member 16 is cut such that the shape of an incident surface 16a is approximately identical to that of a light emitting surface 14a of the semiconductor light-emitting element 14. The light wavelength conversion member 16 is bonded to the semiconductor light-emitting element 14 such that the incident surface 16a of the light wavelength conversion member 16 is fixed firmly to the light emitting surface 14a of the semiconductor light-emitting element 14 using an adhesive 18. The adhesive 18 used herein is a silicone-based adhesive excellent in UV resistance. Such an adhesive is cured for one hour at 150°C and then the light wavelength conversion member 16 is mounted on top of the semiconductor light-emitting element 14. Other adhesive, such as fluorine-based adhesive or sol-or-silica-gel-based adhesive excellent in UV resistance, may also be used as the adhesive 18.

A translucent member sealed with a yellow phosphor 32 and a blue phosphor 34 is used as the translucent member 30 of the light wavelength conversion member 16. The yellow phosphor 32 is excited by light emitted by the semiconductor light-emitting element 14 so as to emit yellow light. The blue phosphor 34 is excited by light emitted by the semiconductor light-emitting element 14 so as to emit blue light. In this manner, the yellow phosphor 32 and the blue phosphor 34 are encapsulated in the transparent translucent member 30 and then the yellow phosphor 32 and the blue phosphor 34 are excited, respectively, so as to be illuminated. As a result, white light is emitted, from the emission surface 16b of the light wavelength conversion member 16, through an additive color mixing of yellow light and blue light. Thus, the light emitting module 10 functions as a white light emitting module. Material and the like used for the yellow phosphor 32 and the blue phosphor 34 differs for each exemplary embodiment and therefore a detailed description of the material and the like will be given when each exemplary embodiment is described below.

It is to be noted that the phosphors contained in the translucent member 30 are not limited to a combination of the yellow phosphor 32 an the blue phosphor 34. For example, a blue phosphor, which is excited by light emitted by the semiconductor light-emitting element 14 and emits blue light, a green phosphor, which is excited thereby and emits green light, and a red phosphor, which is excited thereby and emits red light may be contained in the translucent member 30. In this case, too, white light can be emitted, from the emission surface 16b of the light wavelength conversion member 16, through an additive color mixing of blue light, green light and red light.

Also, the semiconductor light-emitting element 14 may be a blue LED that emits blue light. In this case, a yellow phosphor, which is excited by blue light and emits yellow light, may be contained in the translucent member 30 of the light wavelength conversion member 16. In this case, too, white light can be emitted through an additive color mixing of blue light, which transmits the light wavelength conversion member 16, and yellow light, which is wavelength-converted by the yellow phosphor so as to be emitted. Also, the wavelength of light emitted by the semiconductor light-emitting element 14 and the kind of a phosphor contained in the translucent member 30 may be appropriately selected, in order that light emitted from the light emitting module 10 can be a colored light instead of white light.

### (Exemplary embodiments)

### (1) Phosphors

A cerium-activated yttrium-aluminum phosphor is known as a phosphor for use in a semiconductor light emitting device. However, the refractive index of this phosphor is 1.83, which is quite high, and a difference in refractive index between this phosphor and its binder is large. As a result, the dispersion of light is more likely to occur and therefore attenuation loss of light is more likely to be caused. Accordingly, in the present exemplary embodiments, phosphors capable of efficiently converting near-ultraviolet light and short-wavelength visible light and whose refractive index is 1.7 or less are selected as the yellow phosphor 32 and the blue phosphor 34.

A yellow phosphor whose general formula is as follows (hereinafter referred to as "Y1 phosphor") has a refractive index of 1.63 to 1.68, which is smaller than that of the cerium-activated yttrium-aluminum phosphor. Thus the difference in refractive index between this yellow phosphor and the translucent member 30 is small.

Y1 phosphor: (Ca_{1-x-y-z-w}, Srₓ, M^{II}_{y},Eu_{z},M^{R}_{W})₇(M^{IV}O₃)₆X₂. Here, M^{II} indicates Mg, Ba, or Zn. Also, M^{R} indicates a rare-earth element or Mn. M^{IV}, which contains Si as an essential component, can be partially replaced by at least one type of element selected from the group consisting of Ge, Ti, Zr, and Sn. X, which contains Cl as an essential component, indicates at least one type of halogen element. x, y, z, and w each lies in a range such that 0.1<x<0.7, 0≤y<0.3, 0<z<0.4, and 0<w<0.1, respectively. Accordingly, this Y1 phosphor is used as the yellow phosphor 32.

A blue phosphor whose general formula is as follows (hereinafter referred to as "B1 phosphor") has a refractive index of 1.66 to 1.69, which is smaller than that of the cerium-activated yttrium-aluminum phosphor. Thus the difference in refractive index between this blue phosphor and the translucent member 30 is small.

B1 phosphor: M¹ₐ(M²O₄)_{b}X_{c}:Re_{d}. Here, M¹ contains, as essential component(s), at least one type of element selected from the group consisting of Ca, Sr, and Ba, and can be partially replaced by at least one type of element selected from the group consisting of Mg, Zn, Cd, K, Ag, and Tl. M², which contains at least P as an essential component, can be partially replaced by at least one type of element selected from the group consisting of V, Si, As, Mn, Co, Cr, Mo, W, and B. X indicates at least one type of halogen element. Re, which contains Eu²⁺ as an essential component, indicates at least one type of rare-earth element or Mn. a, b, c, and d each lies in a range such that 2≤a≤5.8, 2.5≤b≤3.5, 0.8<c<1.4, and 0.01<d<0.1, respectively. Accordingly, this B1 phosphor is used as the blue phosphor 34.

These two kinds of phosphors both exhibit high external quantum efficiency in a range of near-ultraviolet light to short-wavelength visible light. Thus, the phosphors are properly excited by light ranging from near-ultraviolet light to short-wavelength visible light whose dominant wavelength is 350 nm to 480 nm (inclusive) by the semiconductor light emitting element 14 according to the present exemplary embodiment. If the yellow phosphor and the blue phosphor indicated by the above formulae are used, more preferable will be the semiconductor light-emitting element 14 that generates light ranging from near-ultraviolet light to short-wavelength visible light whose dominant wavelength ranges from 350 nm to 430 nm (inclusive).

### (2) Translucent member

In the current practice, a general semiconductor light emitting device, which performs wavelength conversion using a phosphor, mounts a phosphor such that the phosphor is bound with a binding material into a certain shape in order that a phosphor in powdery form can be mounted on the semiconductor light-emitting element at high reproducibility. A material used as the binding material is generally selected from resin materials having light permeability. In particular, a resin, which is excellent in photo-deterioration resistance against light emission from the semiconductor light-emitting element, is selected. Such a resin excellent in light transmittance and photo-deterioration resistance may be silicone, fluorine, and sol-gel silica, for instance, and their refractive indices are less than or equal to 1.5, which is low. However, the phosphor that will be dispersed in the resin is composed of composite metal oxide, sulfide, oxynitride, and nitride, and their refractive indices are greater than or equal to 1.6, which is high. A YAG-based phosphor, emitting yellow light, is activated by cerium. This YAG-based phosphor absorbs light of an InGaN-based semiconductor light-emitting element that is used often to a constitute white LED in particular and that emits blue light having a peak wavelength at 440 to 470 nm. And this YAG-based phosphor has a refractive index of 1.83, which is high. As described above, a difference in refractive index between the phosphor and the translucent member is large and therefore the dispersion and scatting of light frequently occurs at an interface of the translucent member and the phosphor. Thus, in order to assure the light transmittance and the photo-deterioration resistance while a high refractive index is achieved, not resin but an inorganic amorphous material is used as the translucent member serving as the biding material.

A sol-gel method, where the starting material is metal alkoxide, or a glass manufacturing method, where SiO₂, B₂O₃ and P₂O₅ are used as main components of glass, is employed in the preparation of the inorganic amorphous material that becomes the biding material.

In the sol-gel method, tetraethyl orthosilicate (TEOS), and a metal alkoxide or metal sol is used as the starting material. The metal alkoxide used herein may be aluminum alkoxide, zirconia alkoxide, hafnia alkoxide, and titania alkoxide, for instance. The metal sol used herein may be alumina sol, zirconia sol, hafnia sol, and titania sol, for instance. The aforementioned raw material is mixed with acid catalyst in an appropriate solvent and then hydrolysis is advanced, thereby preparing a precursor in a sol-gel state. Al-O, Zr-O, and Ti-O bonds are contained in a matrix for the purpose of increasing the refractive index relative to Si-O. Thus, the matrix can be so made that the refractive index can be higher than resin silicone, fluoride, sol-gel silica, or the like that is excellent in photo-deterioration resistance and that the dispersion of light with phosphor contained therein can be suppressed.

In the glass manufacturing method, at least one kind of SiO₂, B₂O₃ and P₂O₅ is contained as an essential component. In order to decrease the melting temperature of glass and increase the refractive index thereof, metallic oxides, such as SnO, ZnO, CaO, BaO, SrO, MgO, K₂O, Na₂O, LiO₂, Bi₂O₃, and Nb₂O₅, are mixed into glass material. The mixed materials are put into a platinum crucible and undergoes a heating process at 800 to 1500°C. In this manner, the softening temperature of the thus produced glass is so adjusted as to be 800°C or less. At this time, Al₂O₃, Ta₂O₅, TiO₂, NbO₅, Gd₂O₃, La₂O₃ or the like may be added to improve the stability against chemical degradation. The glass is ground in a ball mill so that the particle size is 10 µm or less, thereby preparing glass powder material.

The refractive index of glass in the matrix can be adjusted by adjusting an amount of metallic oxides to be contained therein. When P₂O₅, GeO₂, TiO₂, TeO₂, Al₂O₃, Bi₂O₃, V₂O₅, Sb₂O₃, SnO₂ and the like are vitrified in addition to SiO₂ and B₂O₃, a pure glass assumes a structure of a polyhedron coordinated with oxygen (three or four coordinations) and forms a three-dimensional matrix sharing a vertex oxygen. If all oxygen atoms are present as vertex-sharing bridging oxygen, the refractive index will be low. As a typical example, the refractive index of quartz (SiO₂) is 1.45. In order to improve the refractive index of glass in the matrix, it is necessary to contain non-bridging oxygen where a vertex oxygen and a metallic ion of a simple polyhedron form an ionic bond with each other. Thus, the amounts of metallic oxides, such as SnO, ZnO, CaO, BaO, SrO, MgO, K₂O, Na₂O, LiO₂, and Bi₂O₃, which work to increase the refractive index, to be added in glass are adjusted, so that the refractive index can be matched properly. Also, an increase in the non-bridging oxygen resulting from the addition of theses components to raise the refractive index can lower the softening temperature of glass.

When the inorganic amorphous material is mounted to the semiconductor light-emitting element 14, the thickness of the inorganic amorphous material containing the phosphor is preferably in a range of 50 to 600 µm. If the thickness thereof is greater than or equal to 600 µm, the fluorescence will emit from not only the top face of the inorganic amorphous material but also the side faces thereof. Thus, the emission area increases and, as a result, the brightness is reduced. If the inorganic amorphous material is formed thinner such that the thickness thereof is less than or equal to 50 µm, the strength of the inorganic amorphous material will decrease and therefore there will be higher possibilities that the inorganic amorphous material may be broken when it is mounted thereto. This reduces handling ability.

The amount of phosphor contained in the inorganic amorphous material is adjusted. If the amount thereof is 5 vol% or below, the amount of phosphor will be insufficient; the thickness of the wavelength conversion member needs to be 2.5 mm or above in order that light emitted by the semiconductor light-emitting element 14 can be properly absorbed. If a wavelength conversion member having such a large thickness is placed on top of the semiconductor light-emitting element 14, the fluorescence will emit from not only the top face of the wavelength conversion member but also the side faces thereof. As a result, the emission area increases and therefore the brightness is reduced. If, on the other hand, the phosphor of 40 vol% or above is filled, the amount of inorganic amorphous material functioning as a binder that binds the phosphor grains together will be insufficient and some voids will be created inside the wavelength conversion member. The generation of such voids clouds glass and causes light inside the glass to scatter. This causes an attenuation loss of light and therefore it may be difficult to enhance the extraction efficiency of light. Hence, the volume ratio of the phosphor to the glass powder is preferably in a range of 5 to 40 vol%.

### [Adjustment of phosphor]

### (1) Y1 phosphor

For the manufacturing of Y1 phosphors, SiO₂, Ca(OH)₂, SrCl₂(6H₂O), and Eu₂O₃ are first weighed such that the mole ratio of these raw materials is SiO₂: Ca(OH)₂: SrCl₂(6H₂O): Eu₂O₃ = 1.1:0.45:1.0:0.13. The thus weighed raw materials are put in an alumina mortar and then ground and mixed for about thirty minutes so as to obtain a raw material mixture. This raw material mixture is put in an alumina crucible and calcinated in an electric furnace, operated under a reducing atmosphere, for 5 to 40 hours in an atmosphere having a ratio of N₂:H₂ = 5:95 at a temperature of 1000°C so as to obtain a fired product. The thus obtained fired product is thoroughly cleansed with warm pure water so as to obtain Y1 phosphors whose average particle size is 11 µm. The refractive index of the thus obtained Y1 phosphor is measured using the Becke line detection method; as a result, a birefringence is observed on account of a hexagonal platelike form. And the measured value is 1.67.

### (2) B1 phosphor

For the manufacturing of B1 phosphors, CaCO₃, MgCO₃, CaCl₂, CaHPO, and Eu₂O₃ are first weighed such that the mole ratio of these raw materials is CaCO₃: MgCO₃: CaCl₂: CaHPO: Eu₂O₃ = 0.42:0.5:3.0:1.25:0.04. The thus weighed raw materials are put in the alumina mortar and then ground and mixed for about thirty minutes so as to obtain a raw material mixture. This raw material mixture is put in an alumina crucible and calcinated for three hours in an atmosphere of N₂ having an H₂ concentration of 2 to 5% at a temperature ranging from 800°C (inclusive) to 1000°C (exclusive) (namely, in the range of 800°C or above to less than 1000°C) so as to obtain a fired product. The thus obtained fired product is thoroughly cleansed with warm pure water so as to obtain B1 phosphors whose average particle size is 25 µm. The refractive index of the thus obtained B1 phosphor is measured using the Becke line detection method, and the measured value is 1.67.

FIG. 2 shows the emission spectrum L0 of the semiconductor light-emitting element 14, the emission spectrum L1 of B1 phosphor, and the emission spectrum L2 of Y1 phosphor. As evident from FIG. 2, the Y1 phosphor barely absorbs blue light and efficiently emits yellow light. This indicates that even though the Y1 phosphors and the B1 phosphors, which are both mixed in the translucent member 30, constitute the light wavelength conversion member 16, almost no interaction is formed between the Y1 phosphors and the B1 phosphors. Thus, an emission color can be easily adjusted based on the mixture ratio of Y1 phosphor and B1 phosphor.

The thus obtained Y1 phosphors and B1 phosphors are mixed together in a ratio of (Y1 phosphor):(B1 phosphor)=3:2, so as to obtain mixed phosphors. The luminescent chromaticities of the thus obtained mixed phosphors are adjusted to (0.38, 0.38) so as to prepare a phosphor aggregate that emits an emission color.

### [Adjustment of inorganic amorphous material]

### (1) TEOS and metal alkoxide

In the adjustment of gel, tetraethyl orthosilicate (Si(OC₂H₅)₄, hereinafter referred to as "TEOS") and aluminum tri-sec-butoxide (Al[OCH(CH₃)C₂H₅]₃, hereinafter referred to as "ASB") are used as raw materials of silica and alumina, respectively. And ion-exchanged water (H₂O) or ethyl alcohol (C₂H₅OH) is used as a solvent, and organic carboxylic acid is used to attain, as a catalyst, the effect of hydrolyzing the precursor and then performing the polycondensation reaction thereon. At this time, L-tartaric acid ([CH(OH)COOH]₂), citric acid (HOOCCH₂C(OH) (COOH)CH₂-COOH(H₂O)), malic acid (HOOCCH₂CH(OH)COOH), and succinic acid ([CH₂COOH]₂) are used as organic carboxylic acid. A description is given below of an adjustment procedure.

Ethyl alcohol and TEOS are stirred for 30 minutes at room temperature and then organic carboxylic acid, which has been dissolved in the ion-exchanged water, is dripped for 15 to 20 minutes. Then a mixed solution of ASB and ethyl alcohol is dripped into the thus derived mixed solution for 15 to 20 minutes at room temperature. After ethyl alcohol and TEOS have been stirred for an hour at room temperature, the temperature of a system is kept at 60°C in an oil bath whose temperature has been raised to 60°C beforehand. After any one of those samples has been thickened or turned into a gel, it is subjected to aging for 24 hours at 60°C. Then, it is calcinated for 3 hours at 500°C so as to remove the solvent.

### (2) TEOS and metal sol

In the adjustment of gel, TEOS and zirconia sol are used as raw materials, 2-propanol is used as a solvent, and hydrochloric acid is used as a catalyst. TEOS, 2-propanol and hydrochloric acid are put in a beaker and are stirred for 30 minutes, and then zirconia sol is added and mixed. After this, pH is regulated at 5 using ammonia (5 wt%) and the stirring is continued at 50°C, thereby the raw materials into a gel. After the gelling is completed, the gel in this state is subjected to aging for 5 hours. Then, in order to completely finish the hydrolysis, the gel is now moved and put into ion-exchanged water (H₂O) and is subjected to aging there for 24 hours.

Then, the gel prepared in the above-described process is cleansed 5 times with 2-propanol and then ion-exchanged water (H₂O) inside the gel is removed. Then, the gel is moved and put into a solution of 80% TEOS and is subjected to aging there for 48 hours at 50°C. To remove the solution of 80% TEOS remaining inside the reinforced gel, the gel is again cleansed 5 times with 2-propanol. Then, the gel is moved and put into a beaker and is dried there at 70°C. The thus obtained gel is calcinated for 3 hours at 500°C so as to obtain an inorganic amorphous material.

The compounding ratios of the elements described in the above (1) and (2) are shown in composition 1 and composition 2 of FIG. 3.

### [Sealing of phosphors using gel-sol material]

The inorganic amorphous material, where the aforementioned raw materials have been used and adjusted as described in the above (1) and (2), is mixed with a sol, such as alumina, zirconia, hafnia, or titania, in a ratio of 3 to 1. The phosphors are added so that the phosphors account for 10 to 30 vol% in this mixture of the inorganic amorphous material and the sol. Deionized water is further added gradually. When the phosphors added gradually with deionized water exhibits an appropriate degree of viscosity, they are press-formed into a cylindrical shape so as to prepare a tablet.

The tablet is heated at 150°C so as to prepare the precursor of the wavelength conversion member. The heating time is 1 to 6 hours. In this case, the tablet may be formed under a pressurized atmosphere or depressurized atmosphere in order not to produce bubbles in the precursor. After this, the precursor is calcinated for 3 to 8 hours at 400 to 600°C so as to obtain a massive wavelength conversion member.

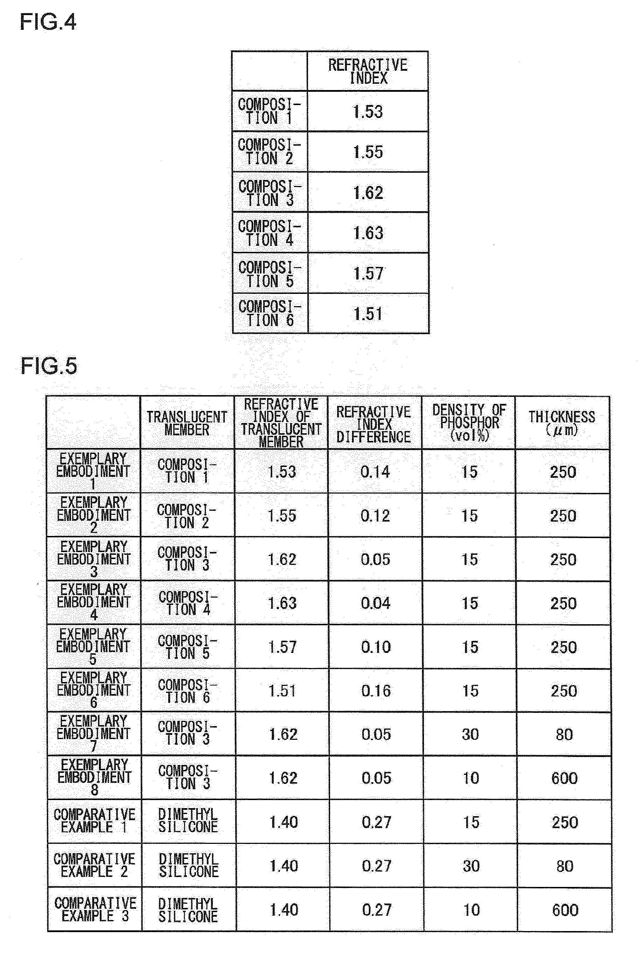

FIG. 3 shows compositions of glass examined in the glass manufacturing method. In the present exemplary embodiment, glass having four kinds of compositions is used. For the manufacturing of the glass having four kinds of compositions, each glass composition is first weighed and mixed, then the mixture of four compositions is melted in the platinum crucible at 900 to 1400°C so as to be vitrified. As a result, the thus vitrified mixture is molded into a shape of film. This film-like glass is ground in the ball mill and then classified. As a result, oxide glass powders whose average particle size is 5 µm are obtained. FIG. 4 shows the refractive index of glass of each composition used in the exemplary embodiment.

### [Sealing of phosphors using glass]

The thus obtained glass powders are combined and mixed with the mixed phosphors so as to obtain mixed powders. The volume ratio of the phosphors to the glass powders is adjusted so that the ratio thereof lies in a range of 10 to 30 vol%. The thus obtained mixed powders are press-formed into a shape of tablet whose diameter is 2 cm and whose thickness is 5 mm. This tablet is heated at 750 to 950°C, namely at the glass softening temperature or above, and the phosphors are sealed in the glass without being cooled, thereby producing a massive wavelength conversion member.

If, in this heating process, the tablet is heated in a depressurized state or pressurized state using inert gas for the purpose of extracting bubbles inside the tablet, a glass-sealed product of high-quality phosphors having no bubbles contained therein can be produced. If the tablet is heated in an air atmosphere as it is, the phosphors will be oxidized and the light-emitting characteristics thereof may deteriorate.

The thus obtained massive light wavelength conversion member is sliced by a diamond cutter or the like into pieces each of which is 50 to 500 µm in thickness and then the surface thereof is polished. This produces the light wavelength conversion member 16 that is a glass plate containing the phosphors.

### [Fabrication of light emitting module]

The semiconductor light-emitting element 14 used for the semiconductor light emitting device fabricated is an InGaN-based LED of flip-chip type having a peak wavelength at 405 nm. This LED is bonded to a base made of aluminum nitride through the medium of an Au bump, which is held between the LED and the base. Here, the based made of aluminum nitride is such that a pattern, made of gold, is formed in a shape of electrode of the semiconductor light-emitting element 14. In this case, the shielding frame 20 is mounted on the substrate 20 in such a manner as to surround the side face 14b of the semiconductor light-emitting element 14 for the purpose of having light, which emits horizontally along the semiconductor light-emitting element 14, emitted efficiently from the light emitting surface 14a. Although, in the exemplary embodiments, the shielding frame 20 is not surface-treated on its inner surface, the inner surface of the shielding frame 20 may be subjected to the surface treatment, by which to enhance reflectance, using aluminum, silver, titanium oxide, or the like.

Then, the light wavelength conversion member 16, which is the inorganic amorphous material containing the phosphors, is mounted on the semiconductor light-emitting element 14. The light wavelength conversion member 16 is cut in advance such that the external shape and the size of the light wavelength conversion member 16 are the same as those of the semiconductor light-emitting element 14. In the exemplary embodiments, the light wavelength conversion member 16 is firmly fixed to the light emitting surface 14a of the semiconductor light-emitting element 14 using the silicone-based adhesive 18.

### (Comparative examples)

In comparative examples, dimethyl silicone whose refractive index is 1.40 is used as the translucent member 30. The Y1 phosphors and the B1 phosphors are sealed in the dimethyl silicone, which is used as a resin binder. In this case, the volume ratio of the Y1 phosphors and the B1 phosphors to dimethyl silicone is similar to the volume ratio thereof to glass. Also, the ratio of the Y1 phosphors and the B1 phosphors to dimethyl silicone is similar to the ratio thereof to the glass plate containing the aforementioned phosphors. This dimethyl silicone containing these phosphors is molded into a shape of film whose thickness is the same as that of the glass plate containing the aforementioned phosphors. This film is cut such that the external shape and the size of the film are the same as those of the light emitting surface 14a of the semiconductor light-emitting element 14. Then, similar to the glass plate containing the phosphors, the film is firmly fixed to the light emitting surface 14a of the semiconductor light-emitting element 14 using the silicone-based adhesive.

### (Results)

FIG. 5 shows the material used for the translucent member 30, the refractive index of the translucent member 30, the difference in the refractive index between the translucent member 30 and Y1 phosphor and B1 phosphor, the density of phosphors, and the thickness of the light wavelength conversion member 16, where the Y1 phosphors and the B1 phosphor are encapsulated, in each exemplary embodiment. In the exemplary embodiments 3 to 6, the density of phosphors is each 15 vol%, the thickness thereof is each 250 µm, and the light wavelength conversion members having the compositions 1 to 4 are used as the translucent members 30, respectively. Although, in the exemplary embodiment 7, the inorganic amorphous having the composition 3 is also used as the translucent member 30, the density of phosphors is 30 vol% and the thickness of the light wavelength conversion member 16 is 80 µm. Although, in the exemplary embodiment 8, the inorganic amorphous having the composition 3 is also used as the translucent member 30, the density of phosphors is 10 vol% and the thickness of the light wavelength conversion member 16 is 600 µm. As a result, the maximum refractive index difference is 0.16 in the exemplary embodiment 4.

In the comparative examples, the same dimethyl silicone is used as the translucent member 30. In the comparative examples 1 to 3, the refractive index difference is each 0.27, which is higher than the refractive index difference in any of the exemplary embodiments 1 to 6. In the comparative example 1, the density of phosphors is 15 vol% and the thickness of the light wavelength conversion member 16 is 250 µm. In the comparative example 2, the density of phosphors is 30 vol% and the thickness of the light wavelength conversion member 16 is 80 µm. In the comparative example 3, the density of phosphors is 10 vol% and the thickness of the light wavelength conversion member 16 is 600 µm.

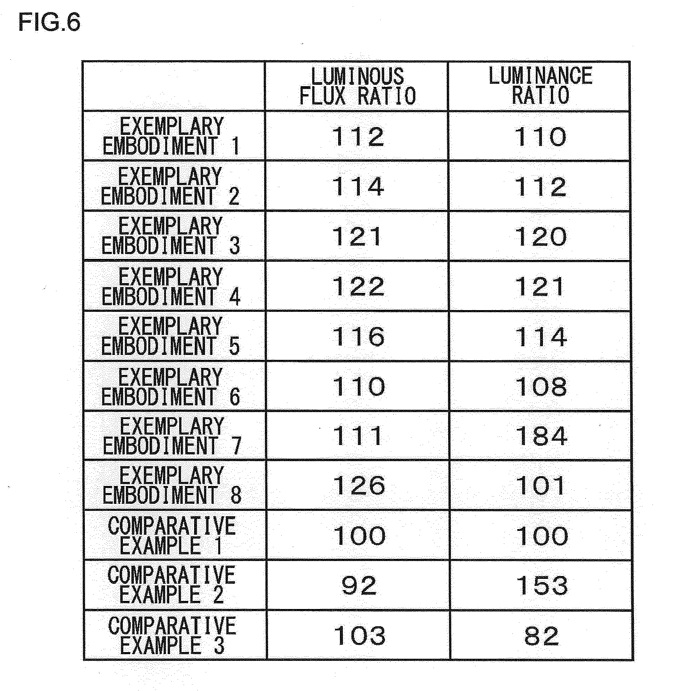

FIG. 6 shows the luminous flux ratio and the luminance ratio of light emitted from the light emitting module 10, in each exemplary embodiment and each comparative example. To measure the luminous flux ratio and the luminance ratio, the light emitting module 10 is driven at 100 mA. FIG. 6 shows the relative values of light flux when the light flux in the comparative example 1 is "100". FIG. 6 also shows the relative values of luminance when the brightness in the comparative example 1 is "100".

As evident from FIG. 6, the light flux or luminance in the comparative examples 2 and 3 is lower than the light flux or luminance in the comparative example 1 but the light flux and the luminance in all of the exemplary embodiments 1 to 6 are higher than those in the comparative example 1. Thus, it turned out that the light flux and the luminance improve if the difference in the refractive index between the translucent member 30 and Y1 phosphor and B1 phosphor is 0.2 or below. Since the maximum value of the refractive index differences in the exemplary embodiments is 0.16, it is assured that the light flux and the luminance can further improve, if the difference in the refractive index between the translucent member 30 and Y1 phosphor and B1 phosphor is 0.16 or below.

In the exemplary embodiments 1 to 8, the light flux is maximum in the exemplary embodiment 8 where the density of phosphors is lowest and the light wavelength conversion member 16 is thickest. As for the luminance, however, no significant improvement is found over that of the comparative examples. The luminance is maximum in the exemplary embodiment 7 where the density of phosphors is highest and the light wavelength conversion member 16 is thinnest. As for the light flux, however, the exemplary embodiments improve by about 10% over the comparative examples. In the exemplary embodiments 3 and 4 where the density of phosphors and the thickness of the light wavelength conversion member 16 each indicates an intermediate value of those in the exemplary embodiments 7 and 8, it is found that both the light flux and the luminance are improved by 20% or above over those of the comparative example 1. In the exemplary embodiments 3 and 4, the difference in the refractive index between the translucent member 30, which is formed of the inorganic amorphous material, and Y1 phosphor and B1 phosphor is 0.05 and 0.04, respectively. Thus, the light flux and the luminance can be improved with larger values if the difference in the refractive index between the translucent member 30 and Y1 phosphor and B1 phosphor is 0.05 or below.

The present invention is not limited to the above-described embodiments only, and those resulting from any appropriate combination of components in the embodiments are also effective as embodiments. Also, it is understood by those skilled in the art that modifications such as various changes in design may be added to the embodiments based on their knowledge and that the embodiments added with such modifications are also within the scope of the present invention.

### [Explanation of Reference Numerals]

- 10: Light emitting module
- 12: Substrate
- 14: Semiconductor light-emitting element
- 14a: Light emitting surface
- 14b: Side face
- 14c: Underside
- 16: Light wavelength conversion member
- 16a: Incident surface
- 16b: Emission surface
- 18: Adhesive
- 20: Shielding frame
- 22: Au bump
- 30: Translucent member
- 32: Yellow phosphor
- 34: Blue phosphor

### [Industrial Applicability]

The present invention is usable for a light wavelength conversion member and, in particular, for a light wavelength conversion member including a phosphor and a translucent member containing the phosphor.

## Claims

1. A light wavelength conversion member comprising:
a phosphor; and
a translucent member containing the phosphor,
wherein a difference in refractive index between the phosphor and the translucent member is less than or equal to 0.2.

2. A light wavelength conversion member according to claim 1, the phosphor including:
a blue phosphor that is excited by light whose wavelength ranges from 350 nm to 480 nm and emits blue light; and
a yellow phosphor that is excited by light whose wavelength ranges from 350 nm to 480 nm and emits yellow light,
wherein the difference in refractive index between each of the blue phosphor and the yellow phosphor and the translucent member is less than or equal to 0.2.

3. A light wavelength conversion member according to claim 2, wherein a general formula of the yellow phosphor is (Ca_{1-x-y-z-w}, Srₓ, M^{II}_{y}, Eu_{z}, M^{R}_{W})₇(M^{IV}O₃)₆X₂, where M^{II} indicates Mg, Ba, or Zn,
M^{R} indicates a rare-earth element or Mn,
M^{IV}, which contains Si as an essential component, is partially replaceable by at least one type of element selected from the group consisting of Ge, Ti, Zr, and Sn,
X, which contains Cl as an essential component, indicates at least one type of halogen element, and
x, y, z, and w each lies in a range such that 0.1<x<0.7, 0≤y<0.3, 0<z<0.4, and 0<w<0.1, respectively.

4. A light wavelength conversion member according to claim 2 or claim 3, wherein a general formula of the blue phosphor is M¹ₐ(M²O₄)_{b}X_{c}:Re_{d}, wherein M¹ contains, as an essential component, at least one type of element selected from the group consisting of Ca, Sr, and Ba, and is partially replaceable by at least one type of element selected from the group consisting of Mg, Zn, Cd, K, Ag, and Tl,
M², which contains at least P as an essential component, is partially replaceable by at least one type of element selected from the group consisting of V, Si, As, Mn, Co, Cr, Mo, W, and B,
X indicates at least one type of halogen element,
Re, which contains Eu²⁺ as an essential component, indicates at least one type of rare-earth element or Mn, and
a, b, c, and d each lies in a range such that 2≤a≤5.8, 2.5≤b≤3.5, 0.8<c<1.4, and 0.01<d<0.1, respectively.

5. A light wavelength conversion member according to any one of claim 1 to claim 4, wherein the translucent member contains inorganic amorphous material.
